# EUROPEAN PATENT APPLICATION

(11) **EP 2 282 350 A2**
(43) Date of publication of application: **09.02.2011**
(21) Application number: 10000206.2
(22) Date of filing: 12.01.2010
(51) Int. Cl.: H01L 31/048, H01L 31/18

(54) **Solar cell module and method of manufacturing the same**

(30) Priority: 06.08.2009 KR 20090072518
(71) Applicant: Samsung Electronics Co., Ltd., Yeongtong-gu Suwon-city, Gyeonggi-do 442-742 (KR)
(72) Inventor: Kim, Dong-Jin, Seoul (KR)
(74) Representative: Weitzel, Wolfgang

(57) **Abstract**

A method for fabricating a solar cell module includes disposing a reflective layer on one side of a thin film solar cell, and laminating the reflective layer with the thin film solar cell. The reflective layer is prepared separately from the thin film solar cell.

## Description

### BACKGROUND OF THE INVENTION

### 1. Field of the Invention

The invention relates to a solar cell module and a method of manufacturing the same.

### 2. Description of the Related Art

A solar cell is a photoelectric conversion device that transforms solar energy into electrical energy, and has been drawing much attention as an infinite but pollution-free next-generation energy source.

A solar cell produces electrical energy by transferring electrons and holes to n-type and p-type semiconductors, respectively, and then collecting electrons and holes in each electrode, when an electron-hole pair ("EHP") is produced by solar light energy absorbed in a photoactive layer inside the semiconductors.

Solar cells are divided into a crystalline solar cell and a thin film solar cell. Among solar cells, since the thin film solar cell has a high light absorption rate in the visible light region compared to the crystalline solar cell, the thin film solar cell may be fabricated in the form of a thin film. With a glass substrate or a plastic substrate, the thin film solar cell may be used to fabricate a large-scale solar cell at a relatively low temperature.

For solar cells, it is important to effectively absorb solar energy emitted from the sun, and to increase efficiency of the solar cell absorbing and using the solar energy from the sun.

Methods for increasing the efficiency of the thin film solar cell include mounting a rear reflection structure on a solar cell. Rear reflection structure may increase the efficiency by reducing or effectively preventing light entering through a front surface of a solar cell from going out of the solar cell through a rear surface thereof, and re-using light reflected by the rear reflection structure in a photoactive layer.

The rear reflection structure may be formed by a sputtering. In this case, however, expensive equipment is required and thus production cost and processing time may be increased.

### BRIEF SUMMARY OF THE INVENTION

An exemplary embodiment of the invention provides a method for fabricating a solar cell module that may reduce production cost and simplify a process.

An exemplary embodiment of the invention provides a solar cell module that may be fabricated through the aforementioned fabrication method and improve reliability.

An exemplary embodiment of a method for fabricating a solar cell module includes disposing a reflective layer on one side of a thin film solar cell, and laminating the reflective layer with the thin film solar cell.

The reflective layer may include applying a reflective material on a base film.

The reflective material may include one of an evaporation, a roll-to-roll, a sol-gel, an electroplating, and a combination thereof.

The reflective material may include one of silver (Ag), copper (Cu), aluminum (Al), nickel (Ni), titanium (Ti), alloys thereof, an opaque organic resin, and a combination thereof.

The reflective layer may be adhered to the thin film solar cell with a thermosetting adhesive.

In the process of disposing the reflective layer on one side of the thin film solar cell, a filler and a protective layer may be disposed on one side of the reflective layer together. In the process of laminating the reflective layer with the thin film solar cell, the reflective layer, the filler, and the protective layer may be simultaneously laminated.

The reflective layer may be laminated at a temperature ranging from about 120 degrees Celsius (°C) to about 180 degrees Celsius (°C).

An exemplary embodiment of a solar cell module includes a light transmitting electrode, a photoactive layer disposed on the light transmitting electrode, an auxiliary electrode disposed on the photoactive layer, and a reflective layer disposed on the auxiliary electrode.

The solar cell module may further include an adhesive disposed in at least a portion between the reflective layer and the auxiliary electrode.

The reflective layer may include a base film and a reflective material applied on one side of the base film.

The reflective material may include one of silver (Ag), copper (Cu), aluminum (Al), nickel (Ni), titanium (Ti), alloys thereof, an opaque organic resin, and a combination thereof.

The base film may include one of paper, a polymer resin, stainless steel, a metal plate, and a combination thereof.

The solar cell module may further include the protective layer disposed on the reflective layer, and a filler disposed between the reflective layer and the protective layer.

The solar cell module may further include an adhesive disposed in at least a portion between the reflective layer and the auxiliary electrode.

The adhesive and the filler may include a thermosetting resin.

### BRIEF DESCRIPTION OF THE DRAWINGS

FIG. 1 is a schematic cross-sectional view of an exemplary embodiment of a solar cell module, according to the invention.
FIG. 2 is a schematic cross-sectional view of an exemplary embodiment of a thin film solar cell, according to the invention.
FIGS. 3A to 6 are cross-sectional views showing sequential processes of an exemplary embodiment of a method of manufacturing the solar cell module shown in FIG. 1.

### DETAILED DESCRIPTION OF THE INVENTION

Exemplary embodiments of the invention will hereinafter be described in detail referring to the following accompanied drawings, and may be easily performed by those who have common knowledge in the related field. However, these embodiments are only exemplary, and the invention is not limited thereto.

In the drawings, the thickness of layers, films, panels, regions, etc., are exaggerated for clarity. Like reference numerals designate like elements throughout the specification. As used herein, the term "and/or" includes any and all combinations of one or more of the associated listed items.

It will be understood that when an element such as a layer, film, region, or substrate is referred to as being "on" another element, it can be directly on the other element or intervening elements may also be present. In contrast, when an element is referred to as being "directly on" another element, there are no intervening elements present.

It will be understood that, although the terms first, second, third, etc., may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the invention.

Spatially relative terms, such as "lower," "upper" and the like, may be used herein for ease of description to describe the relationship of one element or feature to another element(s) or feature(s) as illustrated in the figures. It will be understood that the spatially relative terms are intended to encompass different orientations of the device in use or operation, in addition to the orientation depicted in the figures. For example, if the device in the figures is turned over, elements described as "lower" relative to other elements or features would then be oriented "upper" relative to the other elements or features. Thus, the exemplary term "lower" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

All methods described herein can be performed in a suitable order unless otherwise indicated herein or otherwise clearly contradicted by context. The use of any and all examples, or exemplary language (e.g., "such as"), is intended merely to better illustrate the invention and does not pose a limitation on the scope of the invention unless otherwise claimed. No language in the specification should be construed as indicating any non-claimed element as essential to the practice of the invention as used herein.

Hereinafter, the present invention will be described in detail with reference to the accompanying drawings.

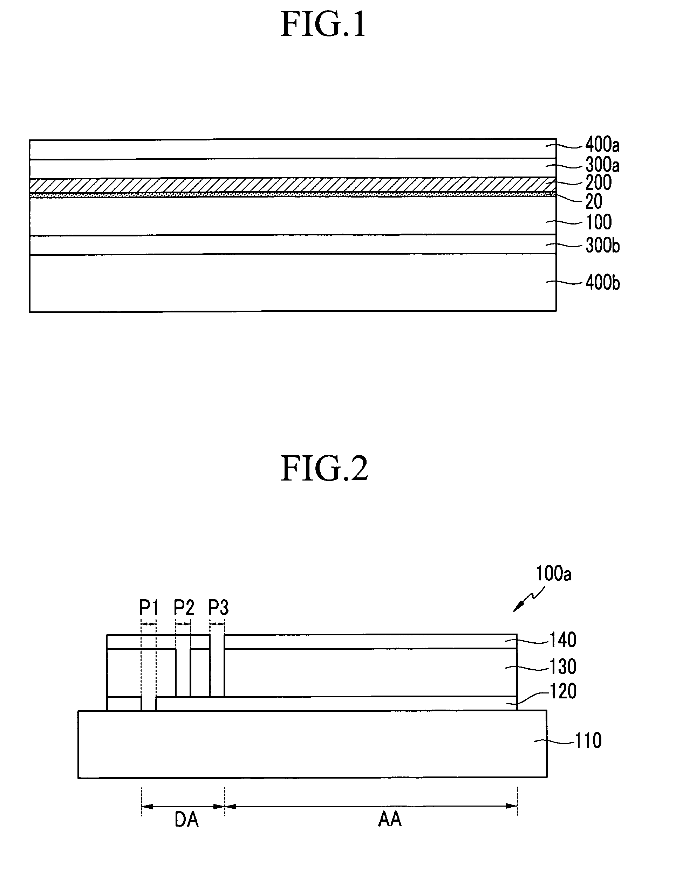

Referring to FIGS. 1 and 2, a solar cell module according to an exemplary embodiment of the invention is described in detail.

FIG. 1 is a schematic cross-sectional view of an exemplary embodiment of a solar cell module, according to the invention, and FIG. 2 is a schematic cross-sectional view of an exemplary embodiment of a thin film solar cell, according to the invention.

Referring to FIG. 1, the solar cell module includes a thin film solar cell 100, a reflective layer 200, a first filler member 300a, and a protective layer 400a disposed on a first side of the thin film solar cell 100, and a second filler member 300b and a protective plate 400b disposed on a second side of the thin film solar cell 100 opposing the first side with respect to the thin film solar cell 100. Also, the solar cell module may further include a fixing member 20, such as an adhesive, disposed between and directly contacting the thin film solar cell 100 and the reflective layer 200.

The thin film solar cell 100 includes a plurality of a unit cell 100a arranged in the form of a matrix in the plan view of the unit cell 100a, and serially electrically connected to each other.

The unit cells 100a of the thin film solar cell 100 will be described with reference to FIG. 2.

Each unit cell 100a includes an active area ("AA") and a non-active area ("DA"). The active area AA is an area where a photoelectric current is generated from solar energy, and is an effective area of a solar cell. The non-active area DA is an area where a plurality of scribe lines for separating the unit cells 100a one from another are disposed.

A light transmitting electrode 120 of the thin film solar cell 100 is disposed on a substrate 110 which includes glass or a plastic material. The substrate 110 may form an outermost layer of the unit cell 100a and/or the thin film solar cell 100. The light transmitting electrode 120 may include a transparent conductive oxide ("TCO"). Non-limiting examples of the transparent conductive oxide include fluorine-doped tin oxide (SnO₂:F, "FTO"), aluminum-doped zinc oxide (ZnO:Al, "ZAO"), boron-doped zinc oxide (ZnO:B), and indium tin oxide ("ITO"). The light transmitting electrode 120 may form an outermost layer of the unit cell 100a and/ or the thin film solar cell 100.

In an exemplary embodiment, the light transmitting electrode 120 may include a textured surface, such as a textured upper surface. The light transmitting electrode 120 with the textured surface may include protrusions and depressions extending outwardly from the upper surface, such as in a pyramid shape, and/or a porous structure extending into the light transmitting electrode 120 from the upper surface, such as a honeycomb. The light transmitting electrode 120 with the textured surface may increase the amount of effective light absorbed into a solar cell by increasing light scattering, and thereby lengthening a light transfer path while reducing reflection of incident light.

A photoactive layer 130 of the thin film solar cell 100 is disposed directly on the light transmitting electrode 120, and opposing the substrate 110 relative to the light transmitting electrode 120. The photoactive layer 130 includes a first impurity doping layer, an intrinsic layer, and a second impurity doping layer. The intrinsic layer may absorb light and generate electric charges such as electrons and holes, and may include intrinsic amorphous silicon (intrinsic a-Si). The first impurity doping layer and the second impurity doping layer may have an internal electric field formed therein, to thereby separate electric charges generated in the intrinsic layer. Either one of the first impurity doping layer and the second impurity doping layer may include silicon doped with a p-type impurity, and the other one may include silicon doped with an n-type impurity.

An auxiliary electrode 140 of the thin film solar cell 100 is disposed directly on the photoactive layer 130. The auxiliary electrode 140 may include a transparent conductive oxide ("TCO"). The auxiliary electrode 140 may form an outermost layer of the unit cell 100a and/ or the thin film solar cell 100.

Referring to FIG. 2, a plurality of scribe lines P1, P2, and P3 of the thin film solar cell 100 are positioned in the non-active area ("DA") to separate adjacent unit cells 110a within the solar cell, and to electrically connect the separated unit cells 110a. The scribe lines P1, P2, and P3 include a first scribe line P1, a second scribe line P2 and a third scribe line P3. The boundaries of the non-active area DA may be defined by outer edges of the first and third scribe lines P1 and P3, respectively.

The first scribe line P1 separates the light transmitting electrode 120 into a plurality of portions, and is disposed extending completely through only the light transmitting electrode 120 in a direction perpendicular to the substrate 110. In the plan view of the solar cell, the first scribe line P1 may be surrounded by the light transmitting electrode 120, such that the light transmitting electrode 120 solely defines the first scribe line P1.

The second scribe line P2 is disposed extending completely through and penetrating only the photoactive layer 130 in the direction perpendicular to the substrate 110. A portion of the auxiliary electrode 140 is disposed within boundaries of the second scribe line P2, so as to completely fill the second scribe line P2. The second scribe line P2 electrically connects the light transmitting electrode 120 with the auxiliary electrode 140. In the plan view of the solar cell, the second scribe line P2 may be surrounded by the photoactive layer 130, such that the photoactive layer 130 solely defines the second scribe line P2.

The third scribe line P3 is disposed extending completely through and penetrating only the photoactive layer 130 and the auxiliary electrode 140 in the direction perpendicular to the substrate 110. The third scribe line P3 is a single continuous member aligned extending through the photoactive layer 130 and the auxiliary electrode 140. In the plan view of the solar cell, the third scribe line P3 may be surrounded by the photoactive layer 130 and the auxiliary electrode 140, such that the photoactive layer 130 and the auxiliary electrode 140 solely define the third scribe line P3.

Referring to FIGS. 1 and 2, the reflective layer 200 of the solar cell module is disposed on the first side of the thin film solar cell 100. The reflective layer 200 may reflect light entering from the second side of the thin film solar cell 100 which passes completely through the thin film solar cell 100, back to the photoactive layer 130.

The reflective layer 200 includes a base film (not shown) and a reflective material disposed on a side of the base film opposing a light incident surface of the base film. Non-limiting examples of the base film include paper, a polymer resin, stainless steel, and a metal plate. Non-limiting examples of the reflective material include one of a metal such as silver (Ag), copper (Cu), aluminum (Al), nickel (Ni), titanium (Ti), and alloys thereof, an opaque organic resin such as a polyester-based resin, and a combination thereof.

Referring again to FIG. 1, the adhesive 20 is applied on one side of the reflective layer 200. The adhesive 20 adheres the thin film solar cell 100 to a reflective layer 200. The adhesive may be applied to at least a portion of the one side of the reflective layer 200, or may be applied on an entire surface of the one side of the reflective layer 200. The adhesive 20 may include a thermosetting resin, and a non-limiting example of the thermosetting resin is epoxy resin.

The reflective layer 200 is disposed on the first side of the thin film solar cell 100. The reflective layer 200 is a separate and independent member from the auxiliary electrode 140. The reflective layer 200 may be formed through an independent lamination process, such as after a laser scribe process for forming a solar cell module. In the illustrated embodiment, a reflection structure (e.g., the reflective layer 200) does not have to be provided inside the thin film solar cell 100, and is disposed as a separate member outside of the thin film solar cell 100 but included within the solar cell module.

When the reflection structure is provided inside the thin film solar cell 100, the scribe process is performed to separate a reflection plate for each unit cell 100a. Where a reflection plate is formed for each unit cell 100a, a defect may originate from imperfect removal of a portion of the reflection plate, or from a portion of a removed reflection structure entering a scribe line to contact the light transmitting electrode and thereby cause a short circuit.

The illustrated embodiment reduces or effectively prevents the aforementioned defects from occurring by not disposing a reflection structure inside the thin film solar cell 100, prevents light entering through a front (e.g., incident) surface of the solar cell from going out of the solar cell through a rear surface opposing the incident surface by including a reflective layer on one side of the thin film solar cell 100 at a rear portion of the solar cell, and increases the efficiency of the solar cell by reflecting the incident light back to the photoactive layer of the thin film solar cell 100.

The solar cell module includes the first and second filler members 300a and 300b disposed at respective first and second sides of the thin film solar cell 100. The first and second filler members 300a and 300b may each include an encapsulation material, and may reduce or effectively prevent the thin film solar cell 100 from degradation due to moisture. The first and second filler members 300a and 300b may include a material having high light transmittance, moisture-proofness, thermal stability, and/or mechanical strength. In one exemplary embodiment, the first and second filler members 300a and 300b may include a thermosetting material, e.g., ethylene vinyl acetate ("EVA"). The first and second filler members 300a and 300b may include a material to be thermoset at the same temperature range as that of the adhesive 20. In alternative exemplary embodiments, the first and second filler members 300a and 300b may be omitted in some cases.

The protective layer 400a and the protective plate 400b are disposed on one side of the fillers 300a and 300b, respectively. The protective layer 400a and the protective plate 400b may form the rearmost and the frontmost layers of the solar cell module, as illustrated in FIG. 1.

The protective layer 400a may be referred to as a back sheet. The protective layer 400a protects the thin film solar cell 100 from being damaged by external impact, and from moisture penetrating through a rear side of the solar cell module. The protective layer 400a is robust to a high-temperature and high-humidity environment, and may include an insulating and durable material. In one exemplary embodiment, a thin film with fluoropolymer-polyester-fluoropolymer sequentially stacked therein may be used as the protective layer 400a.

The protective plate 400b is disposed at a front side of the solar cell module to protect the thin film solar cell 100 from being damaged by external impact. The protective plate 400b may include a material having high light transmittance and high mechanical strength. In one exemplary embodiment, the protective plate 400b may include a tempered glass or plastic material. The protective plate 400b may be treated to prevent surface reflection of incident light from the front side of the solar cell module.

In alternative exemplary embodiments, the protective layer 400a and/or the protective plate 400b may be omitted in some cases.

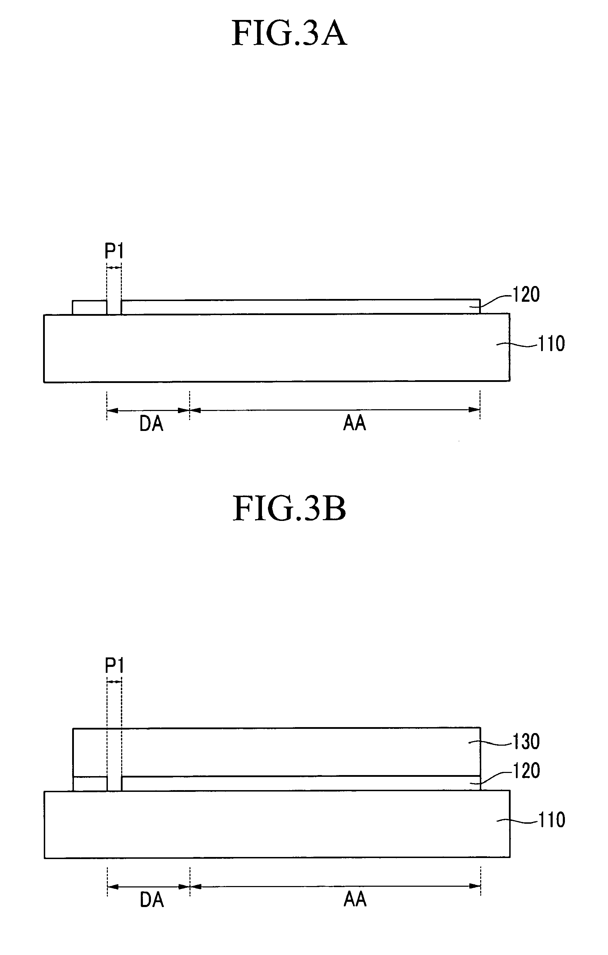

Hereafter an exemplary embodiment of a method for fabricating the solar cell module illustrated in FIGS. 1 and 2 will be described with reference to FIGS. 3A to FIG. 6, along with FIGS. 1 and 2.

FIGS. 3A to 6 are cross-sectional views sequentially showing processes of an exemplary embodiment of a method of manufacturing the solar cell module shown in FIG. 1.

An exemplary embodiment of a method for fabricating the thin film solar cell 100 will be described with reference to FIGS. 3A to 3D along with FIG. 2.

A plurality of a unit cell 100a are formed prior to the fabrication of the thin film solar cell 100.

Referring to FIG. 3A, a light transmitting electrode 120 is formed directly on a lower surface of a substrate 110, e.g., a glass substrate. The light transmitting electrode 120 may be formed by depositing a transparent conductive oxide by a sputtering, chemical vapor deposition ("CVD"), and so forth.

Subsequently, a first scribe line P1 is formed in a non-active area ("DA") of the unit cell 100a, such as by patterning the light transmitting electrode 120 with a scribe device such as a neodymium-doped yttrium aluminium garnet ("Nd:YAG") laser.

Referring to FIG. 3B, an active layer 130 (e.g., photoactive layer) is formed directly on a rear surface of and overlapping the light transmitting electrode 120. The active layer 130 is disposed within boundaries of the first scribe line P1, to completely fill an area of the first scribe line P1. As described above, the active layer 130 may include a first impurity doping layer, an intrinsic layer, and a second impurity doping layer that are sequentially stacked. The active layer 130 may be formed, by for example, a plasma enhanced chemical vapor deposition ("PECVD") method.

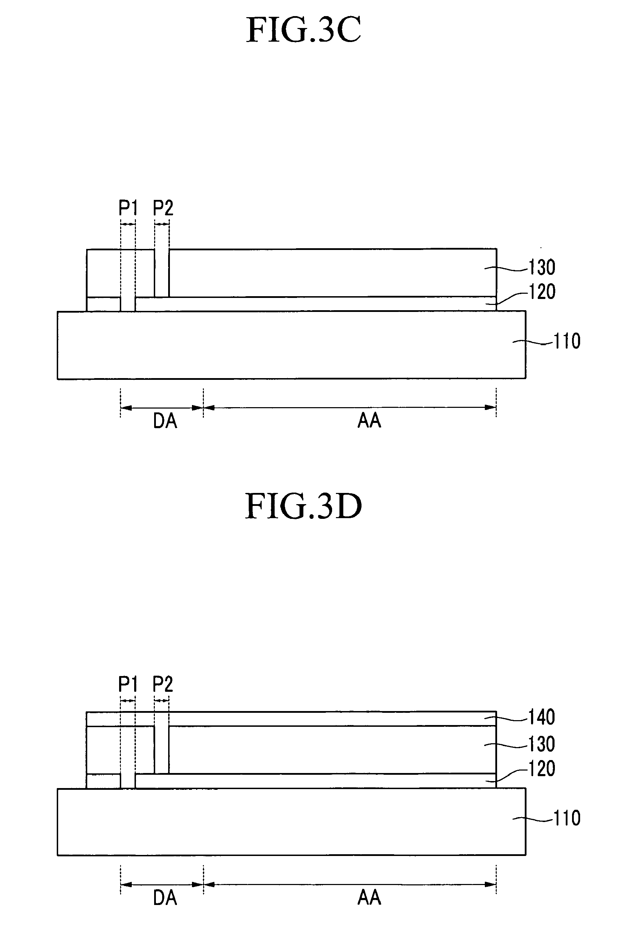

Referring to FIG. 3C, a second scribe line P2 is formed in the non-active area ("DA"), such as by patterning the active layer 130 with a scribe device, such as a Nd:YAG laser. In one exemplary embodiment, a laser of a different frequency from that of the laser used for patterning the light transmitting electrode 120 may be used in order to not damage the light transmitting electrode 120.

Referring to FIG. 3D, an auxiliary electrode 140 is formed directly on a rear surface of the active layer 130. The auxiliary electrode 140 may be formed by depositing a transparent conductive oxide through a method, such as sputtering or chemical vapor deposition ("CVD"). A portion of the auxiliary electrode 140 is disposed within boundaries of the second scribe line P2, to completely fill an area of the second scribe line P2.

Referring to FIG. 2, a third scribe line P3 is formed in the non-active area, such as by patterning the auxiliary electrode 140 and the active layer 130 with a scribe device such as a Nd:YAG laser. The third scribe line P3 is a single continuous member aligned extending through the photoactive layer 130 and the auxiliary electrode 140.

A process of tabbing the fabricated unit cells 110a and a process of stringing the unit cells 110a in series are performed. Subsequently, a thin film solar cell 100 with a plurality of unit cells 110a arrayed in a matrix form is completely fabricated. The formed thin film solar cell 100 may include only the substrate 110, the light transmitting electrode 120, the photoactive layer 130 and the auxiliary electrode 140.

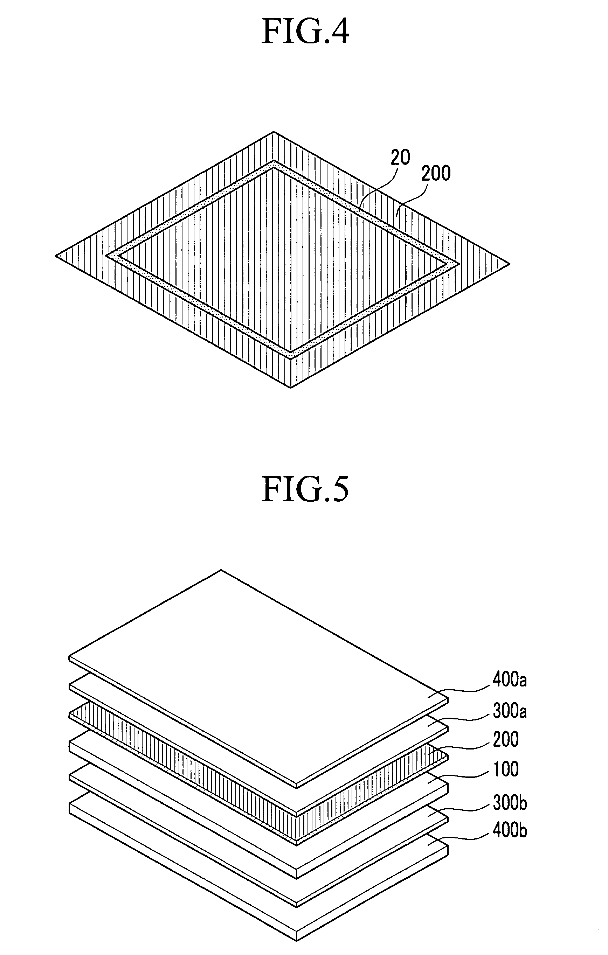

Hereafter, an exemplary embodiment of a method for preparing a reflective layer 200, will be described with reference to FIGS. 1 and 4.

An upper surface of a base film (not shown) is coated with a reflective material. Herein, non-limiting examples of the reflective material may include one of silver (Ag), copper (Cu), aluminum (Al), nickel (Ni), titanium (Ti), alloys thereof, an opaque organic resin, and combinations thereof. The coating process may be performed through a method such as one of evaporation, roll-to-roll, a sol-gel method using metal particles, electroplating, and a combination thereof.

Subsequently, as shown in FIG. 4, an adhesive 20 is applied to a portion of the upper surface of the reflective layer 200. The adhesive 20 may be applied to a region not overlapped with the active area ("AA") in the plan view of the unit cell 100a, when the adhesive is adhered to the thin film solar cell 100. In one exemplary embodiment, the adhesive 20 may be applied to a circumference or at an outer periphery of the reflective layer 200, in the plan view of the solar cell module.

Hereafter, an exemplary embodiment of a lamination process of forming a solar cell module, will be described with reference to FIGS. 1, 5, and 6.

Referring to FIG. 5, a protective plate 400b, a second filler member 300b, the thin film solar cell 100 completely fabricated as above, the reflective layer 200 completely prepared as above, a first filler member 300a, and a protective layer 400a are sequentially stacked overlapping each other. Herein, the reflective layer 200 is disposed in such a manner that the adhesive 20 is directed toward (e.g., faces) the thin film solar cell 100. The protective plate 400b, the second filler member 300b, the thin film solar cell 100 completely fabricated as above, the reflective layer 200 completely prepared as above, the first filler member 300a, and the protective layer 400a are each an individual and separate member from each other, which are subsequently disposed on each other, to completely form the solar cell module.

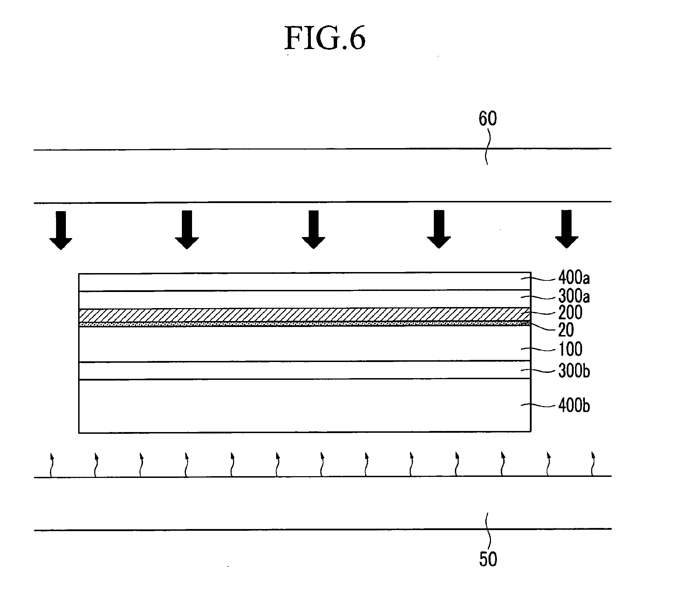

Referring to FIG. 6, the stacked structure including protective plate 400b, the second filler member 300b, the thin film solar cell 100 completely fabricated as above, the reflective layer 200 completely prepared as above, the first filler member 300a, and the protective layer 400a, is disposed in a laminator and pressure is applied thereto. The laminator includes a heater 50 and a compressor 60.

In the lamination process, the first and second filler members 300a and 300b, and the adhesive 20 may be simultaneously thermoset. Herein, the thermosetting temperature may range from about 120 degrees Celsius (°C) to about 180 degrees Celsius (°C). The process of thermosetting may adhere the thin film solar cell 100 to the reflective layer 200, and the respective layers of the solar cell module including the thin film solar cell 100 as an individual member, may be compressed to be sealed hermetically.

According to the illustrated embodiment, an expensive process such as sputtering does not have to be performed when realizing a rear reflection function in a solar cell module with a sheet-type reflective layer on one side of the separately and completely formed thin film solar cell 100. Also, a method of forming the reflective layer 200 on the one side of the thin film solar cell 100 does not require an additional process of separately compressing the reflective layer 200 and the thin film solar cell 100, in the process of laminating the first and second filler members 300a and 300b. While a separate adhesive 20 is used in the illustrated embodiment, an alternative embodiment may not include the separate adhesive 20. In the illustrated embodiment of the invention, since a reflective layer may be formed without an additional process, while not using a method such as sputtering, production time and cost of a solar cell module fabrication process may be reduced.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A method for fabricating a solar cell module, the method comprising:
disposing a reflective layer facing a first side of a thin film solar cell, the reflective layer being prepared separately from the thin film solar cell; and
laminating the reflective layer with the thin film solar cell.

2. The method of claim 1, wherein the reflective layer is formed by applying a reflective material on a base film.

3. The method of claim 2, wherein the reflective material is applied by one of an evaporation, a roll-to-roll, a sol-gel, an electroplating, and a combination thereof.

4. The method of claim 2, wherein the reflective material comprises one of silver (Ag), copper (Cu), aluminum (Al), nickel (Ni), titanium (Ti), alloys thereof, an opaque organic resin, and a combination thereof.

5. The method of claim 2, wherein the reflective layer is adhered to the thin film solar cell with a thermosetting adhesive.

6. The method of claim 1, wherein
in the disposing a reflective layer facing a first side of the thin film solar cell, a filler and a protective layer are disposed on one side of the reflective layer, and
in the laminating the reflective layer with the thin film solar cell, the reflective layer, the filler, and the protective layer are simultaneously laminated.

7. The method of claim 6, wherein the reflective layer is laminated at a temperature ranging from about 120 degrees Celsius (°C) to about 180 degrees Celsius (°C).

8. A solar cell module, comprising:
a light transmitting electrode;
a photoactive layer disposed on the light transmitting electrode;
an auxiliary electrode disposed on the photoactive layer;
wherein the light transmitting electrode, the photoactive layer and the auxiliary electrode collectively form a thin film solar cell; and
a reflective layer disposed on the auxiliary electrode of the thin film solar cell, the reflective layer being a separate member from the thin film solar cell.

9. The solar cell module of claim 8, further comprising
a fixing member disposed between the reflective layer and the auxiliary electrode of the thin film solar cell, and overlapping a portion of the reflective layer.

10. The solar cell module of claim 8, wherein the reflective layer comprises:
a base film; and
a reflective material applied on one side of the base film.

11. The solar cell module of claim 10, wherein the reflective material comprises one of silver (Ag), copper (Cu), aluminum (Al), nickel (Ni), titanium (Ti), alloys thereof, an opaque organic resin, and a combination thereof.

12. The solar cell module of claim 10, wherein the base film comprises one of paper, a polymer resin, stainless steel, a metal plate, and a combination thereof.

13. The solar cell module of claim 8, further comprising:
a protective layer disposed on the reflective layer; and
a filler disposed between the reflective layer and the protective layer.

14. The solar cell module of claim 13, further comprising
a fixing member disposed between the reflective layer and the auxiliary electrode of the thin film solar cell, and overlapping a portion of the reflective layer.

15. The solar cell module of claim 14, wherein the fixing member and the filler comprise a thermosetting resin.
